# EUROPEAN PATENT SPECIFICATION

(11) **EP 2 395 647 B1**
(45) Date of publication and mention of the grant of the patent: **10.04.2019**
(21) Application number: 10738430.7
(22) Date of filing: 25.01.2010
(51) Int. Cl.: H02M 7/48, B60L 9/18, B60L 11/14, H05K 7/14, B60L 15/00, H02M 7/00, H05K 7/20

(54) **POWER CONVERTER**
STROMWANDLER
CONVERTISSEUR DE SECTEUR

(30) Priority: 06.02.2009 JP 2009025499
(43) Date of publication of application: 14.12.2011
(73) Proprietor: Hitachi Automotive Systems, Ltd., Hitachinaka-shi Ibaraki 312-8503 (JP)
(72) Inventor: SUZUKI, Hideyo, Hitachinaka-shi Ibaraki 312-8503 (JP)
(74) Representative: MERH-IP Matias Erny Reichl Hoffmann Patentanwälte PartG mbB
(86) International application number: PCT/JP2010/050912
(87) International publication number: WO 2010/090092

(56) References cited:
- JP-A- 7 130 901
- JP-A- H0 594 854
- JP-A- H08 331 865
- JP-A- 2002 151 647
- JP-A- 2003 318 419
- JP-A- 2003 318 419
- JP-A- 2005 073 373
- JP-A- 2005 287 273
- JP-A- 2006 081 308
- JP-A- 2008 029 117
- JP-U- 4 043 366
- US-A- 5 497 289

## Description

### TECHNICAL FIELD

The present invention relates to a power conversion device that controls a driving motor of a vehicle.

### BACKGROUND ART

Patent literature 2 relates to an inverter apparatus having a compact design and a changeable heat sink. Patent literature 3 relates to a power drive unit, in which the assembling workability shall be enhanced when a control circuit board is attached to a power module. Patent literature 1 states a technology for assembling a power conversion device including a plurality of semiconductor modules with ease and accuracy. More specifically, one control circuit board is provided for a plurality of semiconductor modules, a first protruding section is provided in the semiconductor modules and fitted into a first engaging section provided on the control circuit board, so that positioning is performed with each other.

However, assembly of a semiconductor module and a control circuit board to a power conversion device requires further improvement in assemblability.

### CITATION LIST

### PATENT LITERATURE

PATENT LITERATURE 1: Japanese Laid Open Patent Publication No. 2005-073373
PATENT LITERATURE 2: US 5,497,289 A
PATENT LITERATURE 3: Japanese Laid Open Patent Publication No. 2006-081308 A

### SUMMARY OF INVENTION

### TECHNICAL PROBLEM

An object in the present invention is to improve assemblability of a power conversion device.

### SOLUTION TO PROBLEM

A power conversion device according to the present invention comprises: a power module that converts DC power into AC power and supplies the AC power to a motor; an electronic circuit board, placed above the power module, that drives the power module; and a housing that includes a power module mounting surface on which the power module is mounted, and houses the power module and the electronic circuit board, wherein: the power module includes a first protruding section that is formed to protrude towards the electronic circuit board, and is engaged with a recess or a hole formed on the electronic circuit board; and a second protruding section that is formed to protrude towards the housing, and is engaged with a recess or a hole formed on the housing, wherein: the first protruding section and the second protruding section are aligned on a common longitudinal axis in a direction substantially perpendicular to the power module mounting surface of the housing.

### ADVANTAGEOUS EFFECT OF THE INVENTION

According to the present invention, assemblability of a power conversion device can be improved.

### BRIEF DESCRIPTION OF THE DRAWINGS

FIG. 1 shows external perspective views of a semiconductor module that includes a plurality of semiconductor devices.
FIG. 2 shows views of a plurality of control boards 2001A to 2001C provided on a plurality of semiconductor modules 1000A to 1000C.
FIG. 3 shows schematic views in which a positioning hole of the control board 2001 and the positioning reference of a housing 3001 are collinear.
FIG. 4 shows schematic views in which a positioning hole of the control board 2001 and the positioning reference of the housing 3001 are collinear.
FIG. 5 is a control block diagram of a hybrid vehicle.
FIG. 6 is an enlarged view near a protruding section for positioning provided in a power module 300.
FIG. 7 is an external perspective view of the whole structure of the power conversion device according to an embodiment of the present invention.
FIG. 8 an exploded perspective view of the whole structure of the power conversion device according to an embodiment of the present invention, in which each component is illustrated.
FIG. 9 is a sectional view (with respect to the A-A cross section of FIG. 7) of a power conversion device 200.

### DESCRIPTION OF EMBODIMENTS

A semiconductor module used in a power conversion device outputs, for example, three-phase AC power corresponding to DC power input. Packaging circuit section for outputting the three phases in one semiconductor module will simplify common parts of built-in components or each wiring of the semiconductor module. However, if one of the common parts or each wiring has a problem, the function of the semiconductor module itself is lost. In other words, the yield of the product as a power conversion device may be reduced. On the other hand, if a circuit section constituting one phase of the three phases is packaged in one semiconductor module, the yield of the product can be improved. However, it is necessary to provide a control board for controlling a plurality of semiconductor modules with a multitude of redundant parts such as communication lines for connection of the semiconductor modules and the control board, which may result in an increase in cost.

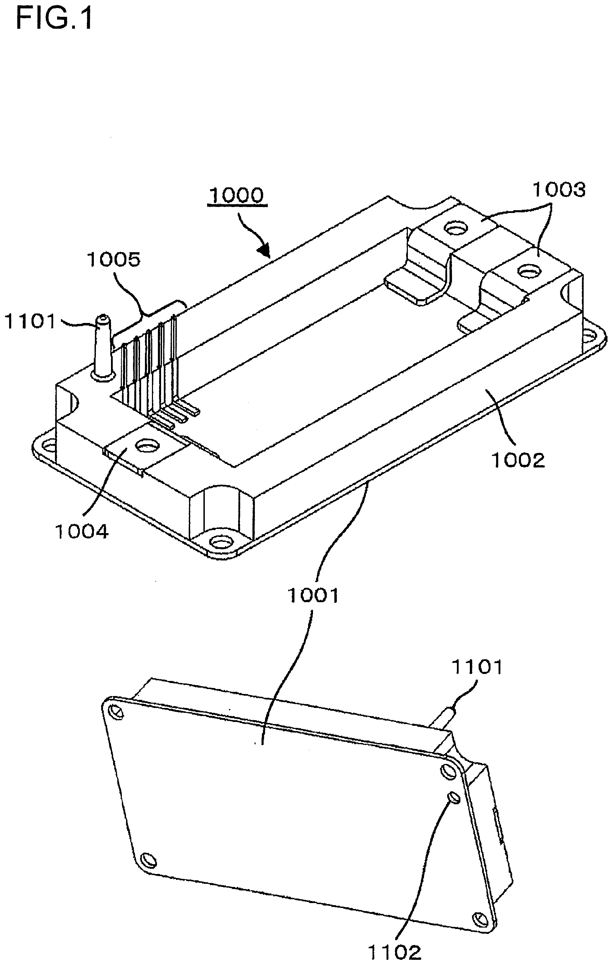

FIG. 1 shows external perspective views of a semiconductor module including a plurality of semiconductor devices. The present semiconductor module includes a metal base 1001 for cooling the internal semiconductor devices, on which the semiconductor devices are mounted. A case 1002 is provided near the outer edge of the metal base 1001. In addition, the case 1002 is formed so that a power input terminal 1003, an output terminal 1004, and a control terminal 1005 are integrated with the case. In other words, the case 1002 serves as an interface between external connection terminals and the internal semiconductor devices.

A protruding section 1101 is provided on the upper surface of the case 1002. The protruding section 1101 serves as a positioning member for a control board to be connected with the control terminals 1005 and the semiconductor module.

A recessed section 1102 is formed a side of the metal base 1001, opposite to the side on which the case 1002 of the metal base 1001 is provided. The recessed section 1102 serves as a positioning member for a housing 3001 for housing the semiconductor module with the semiconductor module.

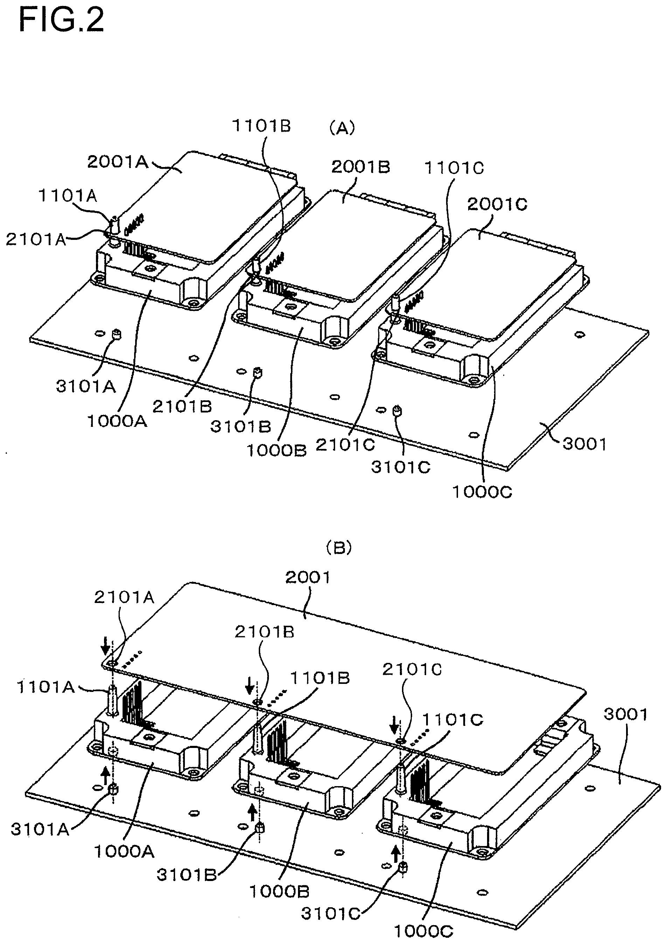

FIG. 2(A), representing background art useful for understanding the present invention, is a view showing a plurality of control boards 2001A to 2001C provided above a plurality of semiconductor modules 1000A to 1000C. The plurality of semiconductor modules 1000A to 1000C are placed on the common housing 3001. The plurality of control boards 2001A to 2001C are each placed above the corresponding semiconductor module.

A protruding section 3101A is provided on the housing 3001 and inserted into the recessed section 1102 described above so as to serve as a positioning member between the semiconductor module 1000A and the housing 3001. On the other hand, the control board 2001A includes a positioning hole 2101A, and the protruding section 1101 described above is inserted into the positioning hole 2101A. In this manner, the position of the semiconductor module 1000A and the control board 2001A is determined. The same is true for the positioning of the semiconductor modules 1000B and 1000C, and the housing 3001, and the control boards 2001B and 2001C.

In the case of FIG. 2(A), the positioning among the housing 3001, the semiconductor module 1000A, and the control board 2001A and the positioning among the housing 3001, the semiconductor module 1000B, and the control board 2001B are independent from one another. In other words, merely the positioning among the housing 3001, the semiconductor module 1000A, and the control board 2001A may be considered, and it is thus unnecessary to consider the positioning among the plurality of control boards 2001A to 2001C with one another, thereby making assembly easy.

On the other hand, FIG. 2(B), representing background art useful for understanding the present invention, is a view showing a control board which integrates the plurality of control boards for cost reduction.

The control board 2001 includes positioning holes 2101A to 2101C into which protruding sections 1101A to 1101C, provided on the semiconductor module 1000A to 1 000C, are inserted. In order to insert the plurality of protruding sections 1101A to 1101C into the corresponding positioning holes 2101A to 2101C, it is necessary to consider dimensional tolerance among the positioning hole 2101A to 2101C in addition to the consideration in the case of FIG. 2(A).

Such cumulative increase in the dimensional tolerance may result in reduction of productivity.

The semiconductor module according to the present embodiment intends to improve productivity while reducing cost increase.

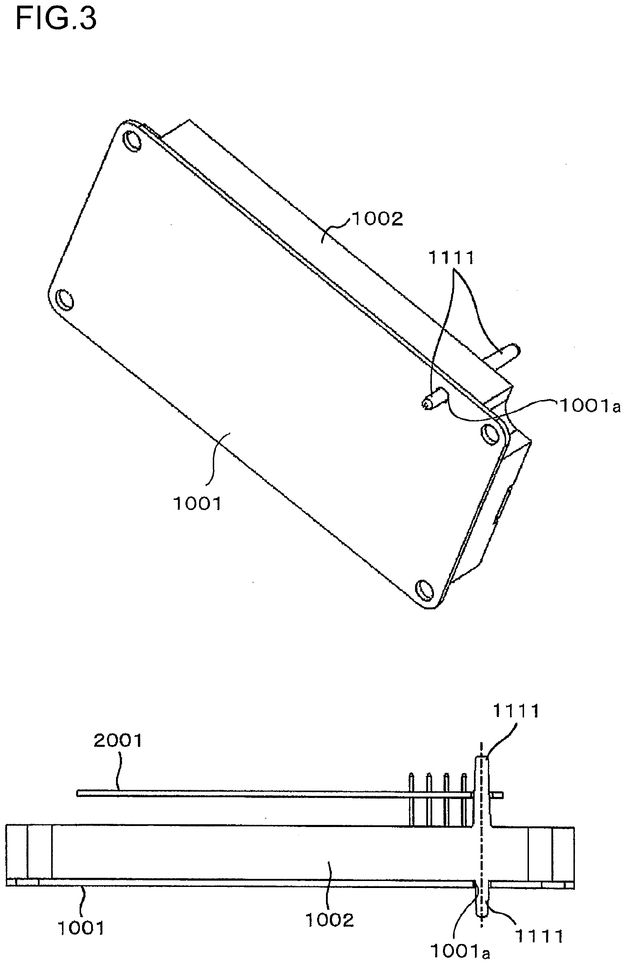

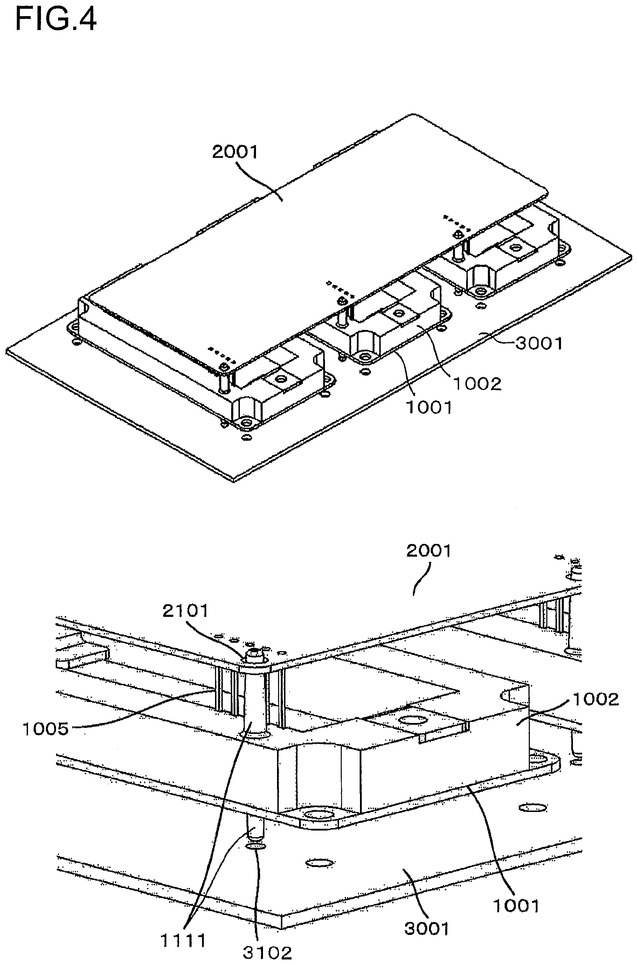

FIG. 3 and FIG. 4 are schematic views of the positioning holes of the control board 2001 and positioning references of the housing 3001 provided in a collinear manner.

As shown in FIG. 3, a positioning member 1111, vertically protruding from the case 1002, is formed integrally with the case 1002. The lower side of the positioning member 1111 protrudes through a hole 1001a, which is formed on the metal base 1001.

FIG. 4 shows the plurality of semiconductor modules shown in FIG. 3, being placed on the common housing 3001. The positioning member 1111 protruding from the bottom of the case 1002 is inserted into a positioning hole 3102 formed on the housing

3001. On the other hand, the positioning member 1111 protruding from the top of the case 1002 is inserted into a positioning hole 2101, formed on the common control board 2001. This allows the semiconductor modules, the control board 2001, and the housing 3001 to be positioned with each other.

It is to be noted that while hereby the positioning is performed by inserting the positioning member 1111 protruding from the top and bottom into the through holes (the positioning holes 2101 and 3102) which are formed on the control board 2001 and the housing 3001, a recess such as the recessed section 1102 described earlier may be formed in place of the through holes.

The positioning member 1111 protruding from the top and bottom can counterbalance the dimensional tolerances between the protruding section for control board positioning and the protruding section for housing positioning, thereby making assembly easy. In addition, it is more advantageous that the positioning member 1111 directly protrudes from the case 1002 in which the power input terminal 1003, the output terminal 1004, and the control terminal 1005 are integrally formed, in terms of the position relationship of the connection sections described earlier.

While the positioning member which has the same reference, protruding vertically from the module is prepared, the positioning member may penetrate through the module upward from the housing and reach an associated component, and may be constituted with a metal bar. In addition, the positioning member may penetrate through the module downward from the associated component and reach the housing, and may be constituted with a metal bar. Obviously, the positioning member may not be penetrated from the module case but be added vertically from the metal base of the module, and may be constituted with a metal bar.

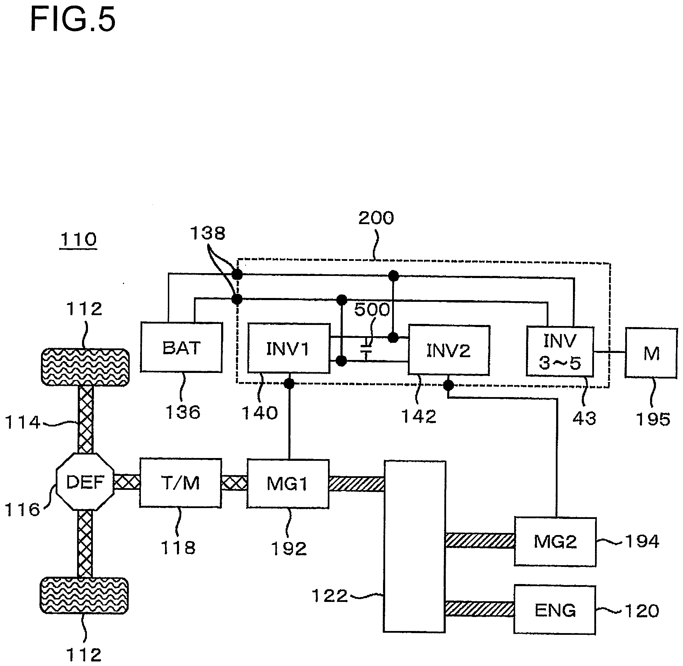

The power conversion device according to an embodiment of the present invention will now be explained in detail with reference to the drawings. While the power conversion device according to an embodiment of the present invention can be applied to a hybrid vehicle and a pure electric vehicle, the control structure when the power conversion device according to an embodiment of the present invention is applied to a hybrid vehicle will now be explained, as a representative example, with reference to FIG. 5. FIG. 5 is a diagram showing a control block of a hybrid vehicle.

With regard to the power conversion device according to an embodiment of the present invention, an explanation will be made in terms of an example of a vehicle-mounted power conversion device of a vehicle-mounted electric machine system to be mounted on a vehicle, in particular, an inverter device for driving a vehicle used in an electric machine system for driving a vehicle, with the inverter device mounted and operated under a very harsh environment. The inverter device for driving a vehicle is included in an electric machine system for driving a vehicle as a control device that controls drive of an electric machine for driving a vehicle. The inverter device converts DC power supplied from a vehicle-mounted battery that constitutes a vehicle-mounted power source or from a vehicle-mounted power generation device into predetermined AC power, and supplies the obtained AC power to the electric machine for driving a vehicle, so as to control drive of the electric machine for driving a vehicle. In addition, since the electric machine for driving a vehicle has a function as an electric generator, the inverter device for driving a vehicle has a function to convert AC power generated by the electric machine for driving a vehicle into DC power according to an operation mode. The converted DC power is supplied to the vehicle-mounted battery.

It is to be noted that, while the structure of the present embodiment is most appropriate for a power conversion device for driving a vehicle, such as an automobile and a truck, the present invention can also be applied to other power conversion devices, for instance, a power conversion device for an electric train, a vessel, an aircraft, and the like, an industrial power conversion device used as a control device for an electric machine that drives plant equipment, or a household power conversion device used as a control device of an electric machine that drives a household photovoltaic power generation system and a household electrical appliances.

In FIG. 5, a hybrid electric vehicle (hereinafter referred to as "HEV") 110 is an electrically powered vehicle that includes two vehicle drive systems. One of them is an engine system with an engine 120, which is an internal combustion engine, as a power source. The engine system is mainly used as a driving source for the HEV 110. The other is a vehicle-mounted electric machine system with motor generators 192 and 194 as power sources. The vehicle-mounted electric machine system is mainly used as a driving source for the HEV and an electric power generation source for the HEV. The motor generators 192 and 194, which are, for example, synchronous machines or induction machines, work as motors or electric generators depending upon the operational method, and hence they are herein referred to as motor generators.

A front axle 114 is rotatably and pivotally supported in a front portion of the vehicle body. A pair of front wheels 112 is provided at both ends of the front axle 114. A rear axle (not shown in the figures) is rotatably and pivotally supported in a rear portion of the vehicle body. A pair of rear wheels is provided at both ends of the rear axle. While the HEV of the present embodiment adopts a so-called front-wheel drive method, in which the front wheels 112 work as primary wheels to be driven on power and the rear wheels work as secondary wheels that follow, it may adopt the contrary, i.e., a rear-wheel drive method.

A front wheel-side differential gear (hereinafter referred to as "front wheel-side DEF") 116 is provided at the middle of the front axle 114. The front axle 114 is mechanically connected to an output side of the front-wheel side DEF 116. An output shaft of a transmission 118 is mechanically connected to an input side of the front-wheel side DEF 116. The front-wheel side DEF 116 is a differential power distribution mechanism that distributes rotational driving force that has been transmitted through the transmission 118 to the right and left of the front axle 114. An output side of the motor generator 192 is mechanically connected to an input side of the transmission 118. An output side of the engine 120 and an output side of the motor generator 194 are mechanically connected to an input side of the motor generator 192 through a power distribution mechanism 122. It is to be noted that the motor generators 192 and 194 and the power distribution mechanism 122 are stored inside a housing of the transmission 118.

The motor generators 192 and 194 are synchronous machines including permanent magnets in rotors, and their drives are controlled as AC power to be supplied to armature coils of stators is controlled by inverter devices 140 and 142. A battery 136 is electrically connected to the inverter devices 140 and 142, so that electric power can be transferred between the battery 136 and the inverter devices 140 and 142.

In the present embodiment, the HEV 110 includes two electric motor generator units, i.e., a first electric motor generator unit constituted with the motor generator 192 and the inverter device 140 and a second electric motor generator unit constituted with the motor generator 194 and the inverter device 142, to be used according to the operational status. More specifically, in order to assist drive torque of the vehicle when the vehicle is driven on power from the engine 120, the second electric motor generator unit is activated, as a power generation unit, on power of the engine 120 so that it generates electric power, and electric power obtained by the power generation causes the first electric motor generator unit to be activated as a motorized unit. In addition, when assisting the vehicle speed in a similar case, the first electric motor generator unit is activated, as a power generation unit, on power of the engine 120 so that it generates electric power, and electric power obtained by the power generation causes the second electric motor generator unit to be activated as a motorized unit.

In addition, in the present embodiment, the first electric motor generator unit is activated on electric power of the battery 136 as a motorized unit so that the vehicle can be driven only on power of the motor generator 192. Furthermore, in the present embodiment, the first electric motor generator unit or the second electric motor generator unit is activated, as a power generation unit, on power of the engine 120 or power from the wheels so as to generate electric power so that the battery 136 can be charged.

The battery 136 is also used as a power source for driving a motor 195 for auxiliaries. The motor for auxiliaries is, for example, a motor that drives a compressor of an air conditioner or a motor that drives a hydraulic pump for controlling. DC power is supplied from the battery 136 to an inverter device 43, converted into AC electric power by the inverter device 43, and supplied to the motor 195. The inverter device 43 has the same function as that of the inverter devices 140 and 142, which controls phase, frequency, and electric power of AC to be supplied to the motor 195. For instance, by supplying leading phase AC power with respect to rotation of the rotor of the motor 195, the motor 195 generates torque. On the other hand, by generating lagging phase AC power, the motor 195 works as an electric generator and the motor 195 operates in a regenerative braking state. Such a control function of the inverter device 43 is the same as the control function of the inverter devices 140 and 142. Since the capacity of the motor 195 is less than that of the motor generators 192 and 194, the maximum conversion electric power of the inverter device 43 is less than that of the inverter devices 140 and 142. However, the circuit configuration of the inverter device 43 is basically the same as that of the inverter devices 140 and 142.

The inverter devices 140 and 142, the inverter device 43, and the capacitor module 500 are in an electrically close relationship. They require in common further measures against heat generation. In addition, the volume of the devices is desirably designed to be as small as possible. From those points, a power conversion device described later in detail houses the inverter devices 140 and 142, the inverter device 43, and the capacitor module 500 in the housing of the power conversion device. This structure allows a small sized, highly reliable device to be achieved.

In addition, arranging the inverter devices 140 and 142, the inverter device 43, and the capacitor module 500 in one housing is effective in simplifying wiring and against noise. In addition, inductance in the connection circuit of the capacitor module 500 with the inverter devices 140 and 142 and the inverter device 43 can be reduced, spike voltage can be reduced, and reduction in heat generation and improved heat dissipation efficiency can be achieved.

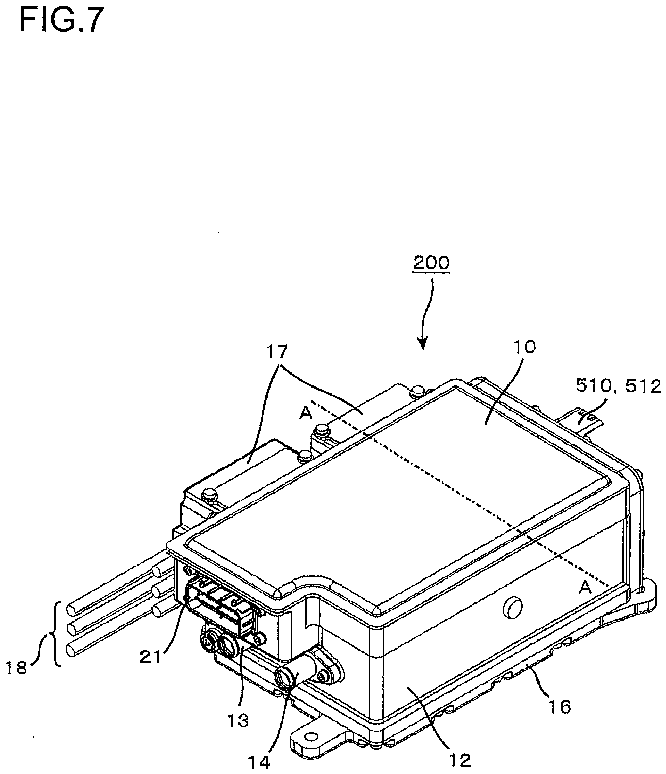

In FIG. 7 to FIG. 9, a reference numeral 200 represents the power conversion device, a reference numeral 10 represents an upper case, a reference numeral 11 represents a metal base plate, a reference numeral 12 represents the housing, a reference numeral 13 represents the cooling water inlet pipe, a reference numeral 14 represents the cooling water outlet pipe, a reference numeral 420 represents a cover, a reference numeral 16 represents a lower case, a reference numeral 17 represents an AC terminal case, a reference numeral 18 represents a AC terminal, a reference numeral 19 represents a cooling water flow path, and a reference numeral 20 represents a control circuit board which holds a control circuit 172. A reference numeral 21 represents a connector for external connection, and a reference numeral 22 represents a drive circuit board which holds a driver circuit 174. A reference numeral 300 represents a power module (semiconductor module unit), and two power modules are provided, with each power module having the built-in inverter circuit. A reference numeral 700 represents a flat laminated bus bar, a reference numeral 800 represents an O-ring, a reference numeral 304 represents a metal base, a reference numeral 188 represents the AC connector, a reference numeral 314 represents the DC positive terminal, a reference numeral 316 represents the DC negative terminal, a reference numeral 500 represents the capacitor module, a reference numeral 502 represents a capacitor case, a reference numeral 504 represents a positive capacitor terminal, a reference numeral 506 represents a negative capacitor terminal, and a reference numeral 514 represents a capacitor cell.

FIG. 7 shows an external perspective view of the whole structure of the power conversion device according to an embodiment of the present invention. The outer configuration of the power conversion device 200 according to the present embodiment is constituted by fixing the housing 12 whose upper surface or bottom surface is substantially rectangular, the cooling water inlet pipe 13 and the cooling water outlet pipe 14 provided on one of outer circumferences on the short side of the housing 12, the upper case 10 for covering an upper opening of the housing 12, and the lower case 16 for covering a lower opening of the housing 12. The housing 12 is shaped to be seen from the top or from the bottom as substantially rectangular so as to be mounted on a vehicle with ease and produced with ease.

Two sets of the AC terminal cases 17 for assisting connection with the motor generators 192 and 194 are provided on the outer circumference of the long side of the power conversion device 200. The AC terminal 18 allows therethrough the power module 300 to be electrically connected with the motor generators 192 and 194 and alternating current output from the power module 300 to be transmitted to the motor generators 192 and 194.

The connector 21 is connected to the control circuit board 20 housed in the housing 12, and a variety of signals from outside are transmitted therethrough to the control circuit board 20. The battery 136 and the capacitor module 500 are electrically connected with each other through a DC (battery) negative electrode-side connection terminal section 510 and a DC (battery) positive electrode-side connection terminal section 512. Here, in the present embodiment, the connector 21 is provided on one side of the outer circumference surface of the short side of the housing 12. On the other hand, the DC (battery) negative electrode-side connection terminal section 510 and the DC (battery) positive electrode-side connection terminal section 512 are provided on the outer circumference surface of the short side opposite to the surface on which the connector 21 is provided. In other words, the connector 21 and the DC (battery) negative electrode-side connection terminal section 510 are separated. This allows the noise which enters the housing 12 through the DC (battery) negative electrode-side connection terminal section 510 and then travels to the connector 21 to be reduced, thereby improving controllability of the motor by the control circuit board 20.

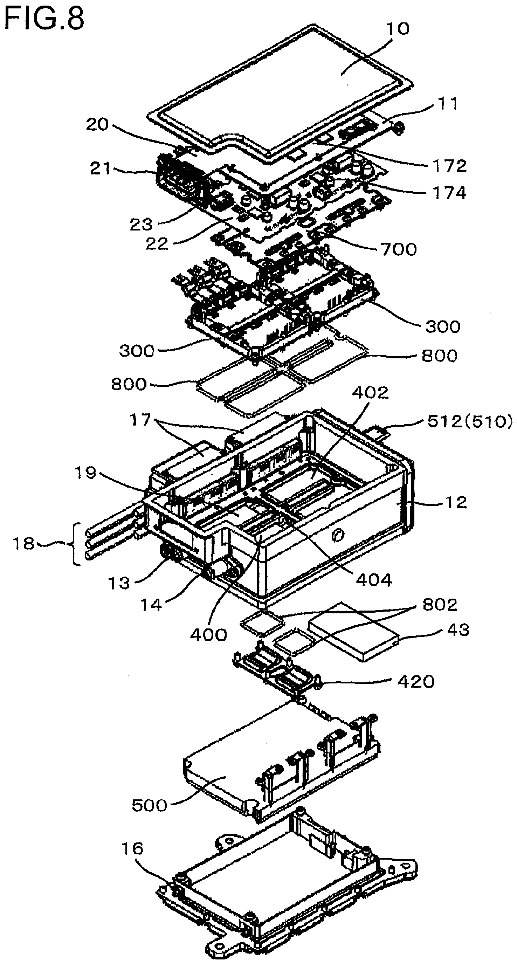

FIG. 8 is an exploded perspective view of the whole structure of the power conversion device according to an embodiment of the present invention, in which each component is illustrated.

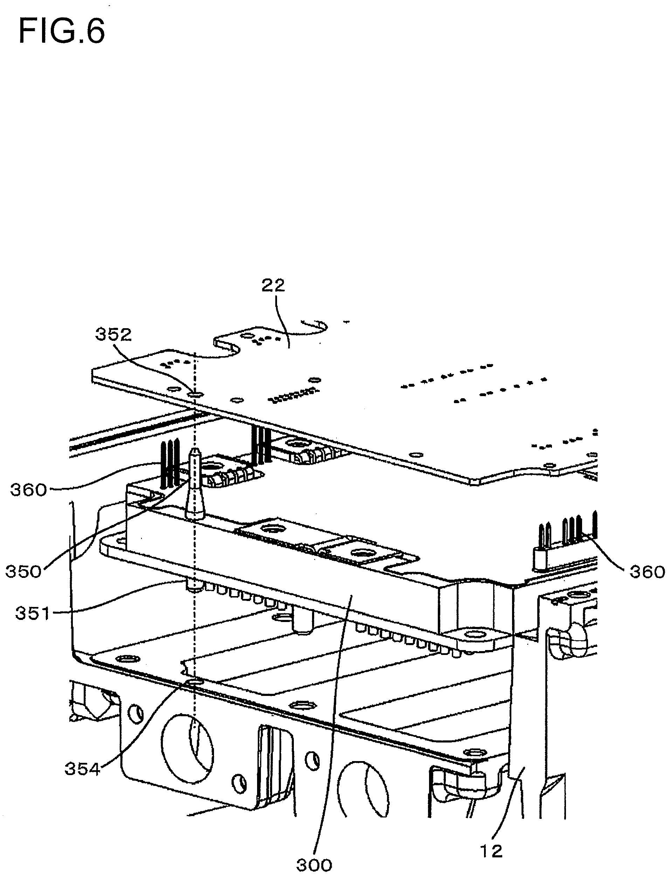

As shown in FIG. 8, the cooling water flow path 19 is provided in the middle of the housing 12, and two openings 400 and 402 are formed along the flow over the cooling water flow path 19. Two power modules 300 are fixed so that each of the openings 400 and 402 is covered with the power module 300. As shown in FIG. 6, a positioning hole 354 is provided above the cooling water flow path 19, and a protruding section 351 for positioning provided on the back side of the power module 300 is inserted into the positioning hole 354 so as to fix the power module 300 over the cooling water flow path 19. It is to be noted that the positioning hole 354 may be any of a through hole and a recessed section (groove) unless there is a problem in relationship with other components. Each of the power modules 300 is provided with fins 305 for heat dissipation, which protrude into the flow of cooling water through the openings 400 and 402 of the cooling water flow path 19.

An opening 404 is formed under the cooling water flow path 19 so as to facilitate aluminium casting, and the opening 404 is covered with the cover 420. The inverter device 43 for auxiliaries is provided beneath the cooling water flow path 19. The inverter device 43 for auxiliaries is provided with a built-in inverter circuit and a power module provided with a built-in power semiconductor device which makes up the inverter circuit. The inverter device 43 for auxiliaries is fixed beneath the cooling water flow path 19, with a heat dissipation metal surface of the built-in power module facing the bottom surface of the cooling water flow path 19. In addition, the O-rings 800 for sealing are provided between the power modules 300 and the housing 12, and furthermore O-rings 802 are provided between the cover 420 and the housing 12. While an O-ring is used as a sealing member in the present embodiment, a resin material, a liquid seal, packing, or the like may be used in place of the O-ring, and, in particular, a use of a liquid seal can improve assemblability of the power conversion device 200.

In addition, the lower case 16 having heat dissipation effect is provided under the cooling water flow path 19. The capacitor module 500 is arranged and fixed on a surface of the lower case 16 so that a heat dissipation surface of a metal case of the capacitor module 500 faces the surface of the lower case 16. This structure allows efficient cooling to be achieved using the top and bottom surfaces of the cooling water flow path 19, thereby leading to reduction in the size of the entire power conversion unit.

The cooling water flows through the cooling water flow path 19 via the cooling water inlet and outlet pipes 13 and 14 so as to cool heat dissipation fins included in the two power modules 300 provided in parallel, thereby cooling the entire two power modules 300. The inverter device 43 for auxiliaries, which is provided beneath the cooling water flow path 19, is cooled at the same time.

In addition, the housing 12, in which the cooling water flow path 19 is provided, is cooled so that the lower case 16, which is provided under the housing 12, is cooled, and, due to this cooling, heat of the capacitor module 500 is thermally conducted to the cooling water through the lower case 16 and the housing 12, thereby cooling the capacitor module 500.

The laminated conductor plate 700 for electrically connecting the power modules 300 with the capacitor module 500 is arranged above the power modules 300. The laminated conductor plate 700 is configured to be wide across the width of the two power modules 300, straddling the two power modules 300. In addition, the laminated conductor plate 700 is constituted with a positive electrode-side conductor plate 702, which is connected with a positive electrode-side terminal of the capacitor module 500, a negative electrode-side conductor plate 704, which is connected with a negative electrode-side terminal thereof, and an insulation member disposed between the positive electrode-side terminal and the negative electrode-side terminal. This enables the layer area of the laminated conductor plate 700 to be increased, thereby reducing parasitic inductance from the power modules 300 to the capacitor module 500. In addition, since, after the one laminated conductor plate 700 is placed on the two power module 300, the laminated conductor plate 700, the power modules 300, and the capacitor module 500 can be electrically connected, the number of assembly steps of even a power conversion device including two power modules 300 can be reduced.

The control circuit board 20 and the drive circuit board 22 are arranged over the laminated conductor plate 700. The driver circuit 174 shown in FIG. 8 is mounted on the drive circuit board 22. The control circuit 172 which includes a CPU shown in FIG. 8 is mounted on the control circuit board 20. In addition, the metal base plate 11 is disposed between the drive circuit board 22 and the control circuit board 20. The metal base plate 11 functions as an electromagnetic shield for circuits mounted on the boards 22 and 20, and also cools the boards by dissipating heat generated by the drive circuit board 22 and the control circuit board 20. Thus, the power conversion device can be efficiently cooled in a small space and the whole power conversion device can be reduced in size by providing the cooling water flow path 19 in the center of the housing 12, arranging the power modules 300 for driving the vehicle on one side of the housing, and arranging the power module 43 for auxiliaries on the other side. In addition, the main structure of the cooling water flow path 19 in the center of the housing is integrally produced with the housing 12 with aluminium casting so as to have an effect to increase mechanical strength, in addition to cooling effect, of the cooling water flow path 19. In addition, aluminium casting allows the housing 12 and the cooling water flow path 19 to have an integrated structure, thereby improving thermal conductivity and cooling efficiency.

The drive circuit board 22 is provided with an interboard connector 23 for connection with the circuits on the control circuit board 20 through the metal base plate 11. In addition, the control circuit board 20 is provided with the connector 21 for electrical connection with outside. The connector 21 allows signal transmission with, for instance, a lithium battery module mounted on the vehicle as the battery 136, which is outside the power conversion device, so that signals indicating battery status or charging status of the lithium battery are sent from the lithium battery module. The drive circuit board 22 is provided with the interboard connector 23 for transferring signals with the control circuit 172 held on the control circuit board 20. A switch timing signal for the inverter circuit is transmitted from the control circuit board 20 to the drive circuit board 22 through a signal line not shown in the figures and the interboard connector 23, and a gate drive signal, which is a drive signal, is generated at the drive circuit board 22 and applied to each of the gate electrodes of the power module.

Openings, formed at an upper part and a lower part of the housing 12, are covered by fixing the upper case 10 and the lower case 16, respectively, to the housing 12, for example, with screws or the like. The cooling water flow path 19 is provided in the center of the housing 12. The power modules 300 and the cover 420 are fixed to the cooling water flow path 19. The cooling water flow path 19 is thus formed and is then tested for water leak. After passing the water leak test, boards and the capacitor module 500 are attached through the upper and lower openings of the housing 12. The configuration with the cooling water flow path 19 provided in the center and the upper and lower openings of the housing 12 through which necessary components are fixed leads to better productivity. In addition, the cooling water flow path 19 is to be completed first, and other components are to be fixed after the water leak test, thereby improving productivity and reliability.

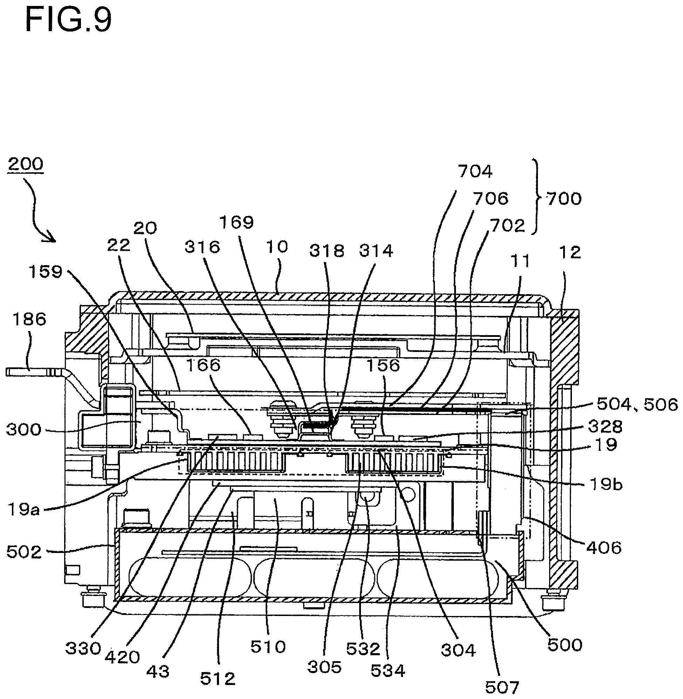

FIG. 9 is a sectional view (with respect to the A-A cross section of FIG. 7) of the power conversion device 200, and the basic structure is as described above.

The cooling water flow path 19 (indicated by a dotted line in FIG. 9) integrally formed of aluminium die cast with the housing 12 is provided at the vertical center of the cross-section of the housing 12. The power modules 300 (indicated by a dashed-dotted line in FIG. 9) are placed in the opening formed at the upper side of the cooling water flow path 19. In FIG. 9, the flow path on the left hand side is a forward path 19a in the forth direction of the cooling water and the flow path on the left hand side is a return path 19b in the reverse direction of the water path. As described above, each of the forward path 19a and the return path 19b is provided with the opening. The power module 300 is provided with the metal base 304 for heat dissipation and the metal base 304 spans over both of the forward path 19a and the return path 19b so as to cover the openings. The metal base 304 is provided with the fins 305 for heat dissipation, and the fins 305 protrude from the openings into the flow of cooling water. In addition, the inverter device 43 for auxiliaries is fixed to the lower side of the cooling water flow path 19.

The plate-like AC electric power line 186 with a bent at the substantial center is connected at its one end to the AC terminal 159 of the power module 300 and protrudes at the other end from inside the power conversion device 200 to constitute an AC connector. The positive capacitor terminal 504 and the negative capacitor terminal 506 are electrically and mechanically connected to the positive electrode-side conductor plate 702 and the negative electrode-side conductor plate 704, respectively, through the through hole 406 (indicated by a dashed-two dotted line in FIG. 9). The cooling water flow path 19 is formed in the substantial center of the housing 12 so as to run back and forth along the long side of the rectangle. The AC terminal 18, the positive capacitor terminal 504, and the negative capacitor terminal 506 are placed substantially perpendicular to the flow direction of the cooling water. Therefore, the electric wirings are orderly arranged, thereby leading to reduction in the size of the power conversion device 200. Since the positive electrode-side conductor plate 702 and the negative electrode-side conductor plate 704 of the laminated conductor plate 700 and the AC side electric power line 186 protrude from the power module 300 and make up the connecting terminal, the structure is very simple. In addition, since another connection conductor is not used, the size is reduced. This structure allows both productivity and reliability to be improved.

In addition, the through hole 406 is separated from the cooling water flow path 19 by a frame body inside the housing 12, and the connection section of the positive electrode-side conductor plate 702 and the negative electrode-side conductor plate 704 with the positive capacitor terminal 504 and the negative capacitor terminal 506 exists inside the through hole 406, thereby improving the reliability.

The power modules 300 with high heating value are fixed on one of the sides of the cooling water flow path 19, and the fins 305 of the power modules 300 protrude into the water path through the openings of the cooling water flow path 19 for efficient cooling. The inverter device 43 for auxiliaries with next higher heat discharge to the power modules 300 is cooled on the other side of the cooling water flow path 19. The capacitor module 500 with next higher heating value to the inverter device 43 is cooled through the housing 12 and the lower case 16. With the cooling structure in accordance with the heating value, the cooling efficiency and reliability are improved and the size of the power conversion device 200 can be reduced more.

In addition, since the inverter device 43 for auxiliaries is fixed at the side of the cooling water flow path 19 toward the capacitor module 500, the capacitor module 500 can be used as a smoothing capacitor for the inverter device 43 for auxiliaries. This configuration allows the wiring length to be reduced, thereby resulting in reduced inductance.

The drive circuit board 22 on which the driver circuit 174 is mounted is placed above the power modules 300. A protruding section 350 for positioning extends upward on the upper surface of the power module 300 as shown in FIG. 6, and the drive circuit board 22 includes a positioning hole 352 shown in FIG. 6. The protruding section 350 described above is inserted into the positioning hole 35, thereby serving as a positioning member.

In addition, as shown by a dashed-dotted line in the FIG. 6, the protruding section 351 for positioning to the housing 12 is provided directly below the protruding section 350. This allows the positioning hole 354 included in the housing 12 to be the positioning reference for the power module 300 and at the same time to be the positioning reference for the drive circuit board 22. In other words, the two modules 300 and the one drive circuit board 22 can be assembled with ease. As a result, a redundant circuit can be removed from the drive circuit board 22, and mounting the circuits is enabled, using the board area effectively and optimally. In addition, it is not necessary to integrate all of the power modules 300, i.e., a use of a plurality of them is allowed, so that the production yield and the like realized by a function included in one module is considered, and thus component cost can be reduced.

It is to be noted that the protruding section 350 and the protruding section 351 are preferably not made of metal but made of, for instance, resin with low electrical conductivity. In the present embodiment, the protruding section 350 and the protruding section 351 are formed on the resin case formed on the outer edge of the power module 300. It is to be noted that the protruding section 351, protruding to the housing 12 side, is formed to penetrate through the metal base of the power module 300. This can prevent switching noise generated in the power module 300 from traveling to the drive circuit board 22.

The drive circuit board 22 has circuit wiring patterns concentrated near the connection section with a gate terminal 360. Thus, the protruding section 350 and the protruding section 351 are provided on a position other than the side of the power module 300 on which the gate terminal 360, which is connected with the switching device in the power module 300. This can prevent the circuit wiring patterns of the drive circuit board 22 and the positioning hole 352 from interfering.

The control circuit board 20 is placed above the drive circuit board 22 through the metal base plate 11, which increases the effects of heat dissipation and electromagnetic shield. It is to be noted that the control circuit 172 shown in FIG. 8 is mounted on the control circuit board 20. The power conversion device 200 according to the present embodiment is constituted by fixing the upper case 10 to the housing 12.

Since, as described above, the drive circuit board 22 is placed between the control circuit board 20 and the power module 300, operation timing of the inverter circuit is transferred from the control circuit board 20 to the drive circuit board 22, and a gate signal is generated at the drive circuit board 22 in response and applied to each gate of the power module 300. Such configuration of the control circuit board 20 and the drive circuit board 22 according to the electrical connection simplifies the electric wiring and reduces the power conversion device 200 in size. In addition, the drive circuit board 22 is placed closer to the control circuit board 20 than the power module 300 and the capacitor module 500 are to the control circuit board 20. Thus, the wiring length from the drive circuit board 22 to the drive circuit board 20 is less than the wiring length between other components (the power module 300 or the like) and the control circuit board 20. As a result, electromagnetic noise traveling from the DC positive electrode-side connection terminal section 512 and electromagnetic noise caused by the switching operation of IGBTs 328 and 330 can be prevented from entering the wiring from the drive circuit board 22 to the drive circuit board 20.

The power modules 300 are fixed to one of the sides of the cooling water flow path 19 and the inverter device 43 for auxiliaries is fixed to the other side so as to allow the cooling water flow path 19 to cool both the power modules 300 and the inverter device 43 for auxiliaries at the same time. In this case, a better cooling effect is realized because the cooling fins of the power modules 300 directly contact the cooling water flowing in the cooling water flow path 19. In addition, the cooling water flow path 19 cools the housing 12 on which the lower case 16 and the metal base plate 11 are fixed so that the capacitor module 500, whose metal case is fixed to the lower case 16, is cooled through the lower case 16 and the housing 12. Likewise, the control circuit board 20 and the drive circuit board 22 are cooled through the metal base plate 11. In addition, the lower case 16, made of highly heat-conductive material, transfers the heat from the capacitor module 500 to the housing 12, and is cooled by the cooling water of the cooling water flow path 19. In addition, the inverter device 43 for auxiliaries with relatively small capacity, which is used for the on-vehicle air conditioner, the oil pump, and other pumps, is placed on the other side which is the side where the lower case 16 of the cooling water flow path 19 exists. The heat from the inverter device 43 for auxiliaries is cooled by the cooling water of the cooling water flow path 19 through the intermediate frame body of the housing 12. Such configuration with the cooling water flow path 19 provided in the center, the metal base plate 11 provided on one side, and the lower case 16 provided on the other side allows the components of the power conversion device 200 to be efficiently cooled in accordance with the heating value. In addition, the components are orderly arranged in the power conversion device 200, thereby reducing the size thereof.

While cooling elements for the power conversion device primarily include the cooling water flow path 19, the metal base plate 11 also functions as a cooling element, i.e., the metal base plate 11 is provided for heat dissipation. The metal base plate 11 functions as an electromagnetic shield, and also transfers the heat from the control circuit board 20 and the drive circuit board 22 to the housing 12 so that the heat is dissipated through the cooling water of the cooling water flow path 19.

Thus, in the power conversion device according to the present embodiment, the cooling element has a three-layer laminated structure, i.e., the metal base plate 11, the cooling water flow path 19, and the lower case 16. These cooling elements are hierarchically placed adjacent to each heating element (the power module 300, the control circuit board 20, the drive circuit board 22, and the capacitor module 500). The cooling water flow path 19, which is the major cooling element, exists in the center of the hierarchical structure. The metal base plate 11 and the lower case 16 transfer the heat to the cooling water of the cooling water flow path 19 through the housing 12. The three cooling elements (the cooling water flow path 19, the metal base plate 11, and the lower case 16) are housed in the housing 12, thereby improving heat dissipation, and reducing thickness and the size. In addition, if the positioning reference 1111 to the housing 12 is provided to the power modules 300, defining the cooling water flow path, and the position of the two modules can be defined, the drive circuit board 22 can be mounted, a redundant circuit will be shared, and the degree of freedom of the circuit mounting will be increased, thereby achieving reduction in cost and size.

## Claims

1. A power conversion device, comprising:
a power module (300) that converts DC power into AC power and supplies the AC power to a motor;
an electronic circuit board (22), placed above the power module (300), that drives the power module (300); and
a housing (12) that includes a power module mounting surface on which the power module (300) is mounted, and houses the power module (300) and the electronic circuit board (22), wherein:
the power module (300) includes:
a first protruding section (350) that is formed to protrude towards the electronic circuit board (22), and is engaged with a recess or a hole (352) formed on the electronic circuit board (22); and
a second protruding section (351) which is formed to protrude towards the housing (12), and is engaged with a recess or a hole (354) formed on the housing (12), wherein:
the first protruding section (350) and the second protruding section (351) are aligned on a common longitudinal axis in a direction perpendicular to the power module mounting surface of the housing (12).

2. A power conversion device according to claim 1, wherein:
a plurality of the power modules (300) are provided, and the plurality of power modules (300) are adjacently placed; and
the electronic circuit board (22) includes a plurality of electronic circuit sections for driving each of the plurality of power modules (22), with the plurality of electronic circuit sections being mounted on a single board.

3. A power conversion device according to claim 1, wherein:
the first protruding section (350) and the second protruding section (351) are integrally formed.

4. A power conversion device according to claim 1, wherein:
the first protruding section (350) is made of resin.

5. A power conversion device according to claim 1, wherein:
the power module (300) includes a case (1002) that surrounds a built-in switching device; and
the first protruding section (350) and the second protruding section (351) are integrally formed with the case (1002).

6. A power conversion device according to claim 5, wherein:
the case (1002), the first protruding section (350), and the second protruding section (351) are made of resin.

7. A power conversion device according to claim 1, wherein:
the power module (300) includes a gate terminal to be electrically connected with a built-in switching device; and
the first protruding section (350) is provided on a side different from a side on which the gate terminal of the power module (300) is provided.

## Patentansprüche

1. Leistungsumsetzungsvorrichtung, die Folgendes umfasst:
ein Leistungsmodul (300), das eine Gleichstromleistung in eine Wechselstromleistung umsetzt und die Wechselstromleistung an einen Motor liefert;
ein elektronische Leiterplatte (22), die über dem Leistungsmodul (300) positioniert ist und die das Leistungsmodul (300) ansteuert; und
ein Gehäuse (12), das eine Leistungsmodulbefestigungsfläche enthält, auf der das Leistungsmodul (300) angebracht ist, und das das Leistungsmodul (300) und die elektronische Leiterplatte (22) aufnimmt, wobei:
das Leistungsmodul (300) enthält:
einen ersten vorstehenden Abschnitt (350), der so gebildet ist, dass er in Richtung der elektronischen Leiterplatte (22) vorsteht und mit einer Aussparung oder einem Loch (352), das auf der elektronischen Leiterplatte (22) gebildet ist, in Eingriff ist; und
einen zweiten vorstehenden Abschnitt (351), der so gebildet ist, dass er in Richtung des Gehäuses (12) vorsteht und mit einer Aussparung oder einem Loch (354), das auf dem Gehäuse (12) gebildet ist, in Eingriff ist, wobei:
der erste vorstehende Abschnitt (350) und der zweite vorstehende Abschnitt (351) auf einer gemeinsamen Längsachse in eine Richtung senkrecht zu der Leistungsmodulbefestigungsfläche des Gehäuses (12) ausgerichtet sind.

2. Leistungsumsetzungsvorrichtung nach Anspruch 1, wobei:
mehrere Leistungsmodule (300) vorgesehen sind und die mehreren Leistungsmodule (300) benachbart positioniert sind; und
die elektronische Leiterplatte (22) mehrere elektronische Schaltungsabschnitte zum Ansteuern jedes der mehreren Leistungsmodule (22) enthält, wobei die mehreren elektronischen Schaltungsabschnitte auf einer einzigen Platte angebracht sind.

3. Leistungsumsetzungsvorrichtung nach Anspruch 1, wobei:
der erste vorstehende Abschnitt (350) und der zweite vorstehende Abschnitt (351) einteilig gebildet sind.

4. Leistungsumsetzungsvorrichtung nach Anspruch 1, wobei:
der erste vorstehende Abschnitt (350) aus Harz hergestellt ist.

5. Leistungsumsetzungsvorrichtung nach Anspruch 1, wobei:
das Leistungsmodul (300) ein Gehäuse (1002) enthält, das eine eingebaute Schaltvorrichtung umgibt; und
der erste vorstehende Abschnitt (350) und der zweite vorstehende Abschnitt (351) einteilig mit dem Gehäuse (1002) gebildet sind.

6. Leistungsumsetzungsvorrichtung nach Anspruch 5, wobei:
das Gehäuse (1002), der erste vorstehende Abschnitt (350) und der zweite vorstehende Abschnitt (351) aus Harz hergestellt sind.

7. Leistungsumsetzungsvorrichtung nach Anspruch 1, wobei:
das Leistungsmodul (300) einen Gate-Anschluss enthält, der mit einer eingebauten Schaltvorrichtung elektrisch zu verbinden ist; und
der erste vorstehende Abschnitt (350) auf einer Seite vorgesehen ist, die von einer Seite verschieden ist, auf der der Gate-Anschluss des Leistungsmoduls (300) vorgesehen ist.

## Revendications

1. Dispositif de conversion de puissance, comprenant :
un module de puissance (300) qui convertit une énergie à courant continu CC en une énergie à courant alternatif CA et alimente l'énergie CA vers un moteur ;
une carte de circuit électronique (22) placée au-dessus du module de puissance (300), qui pilote le module de puissance (300) ; et
un logement (12) qui inclut une surface de montage de module de puissance sur laquelle le module de puissance (300) est monté, et qui renferme le module puissance (300) et la carte de circuit électronique (22), dans lequel :
le module de puissance (300) inclut :
une première section de projection (350) qui est formée pour se projeter en direction de la carte de circuit électronique (22), et qui est engagée avec un renfoncement ou un trou (352) formé sur la carte de circuit électronique (22) ; et
une deuxième section de projection (351) qui est formée pour se projeter en direction du logement (12), et qui est engagée avec un renfoncement ou un trou (354) formé sur le logement (12), dans lequel :
la première section de projection (350) et la deuxième section de projection (351) sont alignées sur un axe longitudinal commun dans une direction perpendiculaire à la surface de montage de module de puissance du logement (12).

2. Dispositif de conversion de puissance selon la revendication 1, dans lequel :
il est prévu une pluralité de modules de puissance (300), et la pluralité de modules de puissance (300) sont placés de manière adjacente ; et
la carte de circuit électronique (22) inclut une pluralité de sections de circuit électronique pour piloter chaque module de puissance parmi la pluralité de modules de puissance (22), la pluralité de sections de circuit électronique étant montés sur une seule carte.

3. Dispositif de conversion de puissance selon la revendication 1, dans lequel :
la première section de projection (350) et la deuxième section de projection (351) sont formées de manière intégrale.

4. Dispositif de conversion de puissance selon la revendication 1, dans lequel :
la première section de projection (350) est faite de résine.

5. Dispositif de conversion de puissance selon la revendication 1, dans lequel :
le module de puissance (300) inclut un boîtier (1002) qui entoure un dispositif de commutation intégré ; et
la première section de projection (350) et la deuxième section de projection (351) sont formées de manière intégrale avec le boîtier (1002).

6. Dispositif de conversion de puissance selon la revendication 5, dans lequel :
le boîtier (1002), la première section de projection (350) et la deuxième section de projection (351) sont faites de résine.

7. Dispositif de conversion de puissance selon la revendication 1, dans lequel :
le module de puissance (300) inclut une borne de grille qu'il s'agit de connecter électriquement avec un dispositif de commutation intégré ; et
la première section de projection (350) est prévue sur un côté différent d'un côté sur lequel la borne de grille du module de puissance (300) est prévue.
